Europäisches Patentamt

European Patent Office

Office européen des brevets

(19)

(11) Veröffentlichungsnummer : **0 069 902**
**B1**

# (12) EUROPÄISCHE PATENTSCHRIFT

(45) Veröffentlichungstag der Patentschrift :
06.05.87

(21) Anmeldenummer : 82105679.3

(22) Anmeldetag : 26.06.82

(51) Int. Cl.⁴ : **H 01 L 25/04**

(54) **Stromrichteranordnung.**

(30) Priorität : 11.07.81 DE 3127456

(43) Veröffentlichungstag der Anmeldung :
**19.01.83 Patentblatt 83/03**

(45) Bekanntmachung des Hinweises auf die Patenterteilung : 06.05.87 **Patentblatt 87/19**

(84) Benannte Vertragsstaaten :
**AT BE CH FR GB IT LI NL SE**

(56) Entgegenhaltungen :
**DE-A- 2 840 514**

(73) Patentinhaber : BROWN, BOVERI & CIE Aktiengesellschaft
Kallstadter Strasse 1
D-6800 Mannheim 31 (DE)

(72) Erfinder : **Neidig, Arno, Dr. Dipl.-Phys.**
**Brühlerweg 42**
**D-6831 Plankstadt (DE)**
Erfinder : **Hettmann, Hubert**
**Waldstrasse 16**
**D-6832 Hockenheim (DE)**
Erfinder : **Leukel, Bernd, Dipl.-Ing.**
**Karlsruherstrasse 19**
**D-6940 Weinheim (DE)**
Erfinder : **Rief, Rolf**
**Wilhelmswörthstrasse 12**
**D-6800 Mannheim (DE)**

(74) Vertreter : **Kempe, Wolfgang, Dr. et al**
**c/o BROWN, BOVERI & CIE AG ZPT Postfach 351**
**D-6800 Mannheim 31 (DE)**

EP 0 069 902 B1

## Beschreibung

Die Erfindung bezieht sich auf eine Stromrichteranordnung nach dem Oberbegriff des Anspruchs 1.

Vergossene Stromrichtersätze, auch als Module bezeichnet, sind allgemein bekannt. Für Zweigpaar-Schaltungen von Thyristoren und Dioden gibt es bereits ein international eingeführtes Gehäuse, das nach Aufbau und Größe für den Dauergrenzstrombereich zwischen 20 A und 100 A geeignet ist. Für Stromstärken unter 20 Ampere ist der Kapselungsaufwand jedoch zu groß, d. h. der Einbau der leistungsschwächeren Schaltung in ein für eine leistungsstärkere Schaltung vorgesehenes Gehäuse führt zu unnötig hohem Material- und Montageaufwand bei der Herstellung und der Anwender muß unnötig große Montageflächen zur Verfügung stellen.

Als Alternative hierzu wird in einem Prospekt der Firma Semikron Gesellschaft für Gleichrichterbau und Elektronik m. b. H., Nürnberg, « Glaspassivierte Thyristor-Tabletten, Semipack » eine Stromrichteranordnung mit einem relativ kleinen Gehäuse vorgeschlagen : Semipack 0, SKKT 15, SKKH 15, SKKD 15, SKKE 15. Selbst dieses verhältnismäßig kleine Gehäuse hat in nachteiliger Weise einen großen Platzbedarf. Es besitzt eine massive Grundplatte aus vernickeltem Kupfer. Dadurch wird zwar ein Durchbiegen der Grundplatte nach den Löt- und Kapselungsprozessen weitgehend vermieden, das Verfahren zur Aufbringung der Grundplatte ist jedoch relativ aufwendig.

Für leistungsschwächere Zweigpaarschaltungen wird von einem anderen Hersteller (MEDL/AEI) bereits ein noch kleineres Modul angeboten : Reihe PB... Auch bei dieser Ausführung ist die isolierte Keramik mit einer metallischen Grundplatte verlötet.

Eine weitere Modulausführung ist aus der DE-A-2 840 514 bekannt. Darin wird ein Modul mit einem haubenförmigen Kunststoffgehäuse beschrieben, in das als Bodenfläche eine Keramikplatte in eine Ausnehmung am Gehäuse eingesetzt ist.

Der Erfindung liegt ausgehend von der DE-A-2 840 514 die Aufgabe zugrunde, eine kostengünstig herstellbare Stromrichteranordnung, insbesondere für Zweigpaarschaltungen mit Stromstärken kleiner als 25 A zu schaffen, deren Abmessungen möglichst gering sind und die sich auch für einen direkten Leiterplatten-Einbau eignet.

Diese Aufgabe wird bei einer gattungsgemäßen Stromrichteranordnung nach Anspruch 1 durch dessen kennzeichnende Merkmale gelöst.

Die mit der Erfindung erzielbaren Vorteile liegen insbesondere darin, daß der Flächenbedarf der Stromrichteranordnung allein durch die Mindestgröße der Keramikplatte bestimmt wird und auch die Höhe der Anordnung geringer ist als bei bekannten Modulen. Der Montage- und Kapselungsaufwand der Anordnung ist vorteilhaft gering. Im Gegensatz zu bekannten Stromrichteranordnungen hat nicht das Gehäuse selbst die tragende Funktion des Moduls, sondern die Keramikplatte.

Ausführungsbeispiele der Erfindung sind nachfolgend anhand der Zeichnungen erläutert. Es zeigen :

Figur 1   eine Stellerschaltung aus zwei antiparallel geschalteten Thyristoren,

Figur 2   einen Kunststoffrahmen hierzu,

Figur 3   das elektrische Schaltbild zur Stellerschaltung,

Figur 4   das vergossene Stromrichtermodul,

Figur 5   ein Thyristor-Zweigpaar,

Figur 6   einen Kunststoffrahmen hierzu,

Figur 7   einen Schnitt durch den Rahmen,

Figur 8   das elektrische Schaltbild zum Zweigpaar.

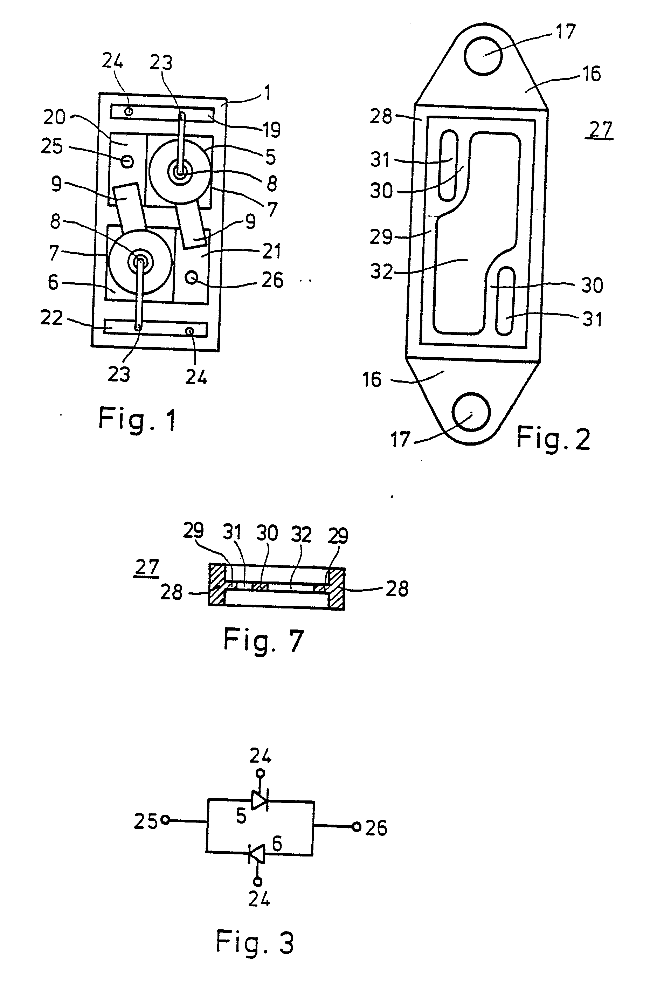

In Fig. 1 ist eine Stellerschaltung, bestehend aus zwei antiparallel geschalteten Thyristoren dargestellt. Auf der rechteckförmigen Keramikplatte 1 sind als Leiterbahnen dienende Kupferfolien 19, 20, 21 und 22 gemäß dem aus Patentanmeldung DE-A-3 036 128 bekannten Verfahren aufgebracht. Auf jeder Kupferfolie 20 bzw. 21 ist jeweils eine Halbleitertablette 5 bzw. 6 (Thyristoren) mit ihrer Anodenseite gelötet. Der ringförmige Kathodenkontakt 7 und der als Zentralgate ausgebildete Gatekontakt 8 liegen auf der der Anodenseite gegenüberliegenden Seite jeder Halbleitertablette 5, 6.

Der Kathodenkontakt 7 der Halbleitertablette 5 ist über eine Verbindungslasche 9 mit der Kupferfolie 21 und damit mit der Anode der Halbleitertablette 6 verbunden. Die Verbindungslasche 9 ist dabei einerseits mit dem ringförmigen Kathodenkontakt 7, andererseits mit der Kupferfolie 21 verlötet. Auf gleiche Weise ist der Kathodenkontakt 7 der Halbleitertablette 6 über eine Verbindungslasche 9 mit der Kupferfolie 20 verbunden. Auf die Kupferfolien 20 und 21 sind Anoden-Kathoden-Anschlußdrähte 25 und 26 gelötet. Die Anschlußdrähte 25 und 26 weisen jeweils ein verdicktes Fußteil zur Erhöhung der Stabilität der Lötstelle auf.

Der zentrale Gatekontakt 8 der Halbleitertablette 5 ist über eine Gate-Verbindungslasche 23 mit der Kupferfolie 19 verbunden, wobei beide Enden der Lasche 23 verlötet sind. Auf der Kupferfolie 19 ist ferner ein Anschlußdraht 24 für den externen Gateanschluß verlötet.

In Fig. 2 ist der Kunststoffrahmen 27 für die bestückte Keramikplatte 1 gemäß Fig. 1 dargestellt. Der Rahmen 27 weist eine umlaufende, breite, im Querschnitt rechteckige Kante 28 auf, an die zum Rahmeninneren hin eine schmale, umlaufende Rippe 29 so angeformt ist, daß die Kanten-Rippen-Anordnung im Querschnitt T-förmig ist. An die innere umlaufende Rippe 29 sind zwei Stützstreben 30 so angeformt, daß sich zwischen innerer Rippe 29 und stützstrebe 30 jeweils längliche Öffnungen 31 zum Durchstecken der Anschlußdrähte 24, 25, 26 ergeben. Das offene, durch den Rahmen begrenzte Gehäuseinnere ist mit 32 bezeichnet.

Der Rahmen 27 kann an seinen beiden Schmalseiten mit angeformten Anschlußlaschen 16 versehen sein, wobei in den Laschen 16 Bohrungen 17 zur Niet- bzw. Schraubbefestigung auf einem Kühlkörper bzw. einer Metallgrundplatte vorgesehen sind.

In Fig. 7 ist ein Schnitt durch den Rahmen 27 dargestellt. Daraus sind der rechteckförmige Querschnitt der umlaufenden Kante 28 sowie die angeformte innere umlaufende Rippe 29 ersichtlich. Zwischen Stützstrebe 30 und Rippe 29 befindet sich einerseits die Öffnung 31 zur Durchführung der Drähte 24 und 25, andererseits das offene Gehäuseinnere 32.

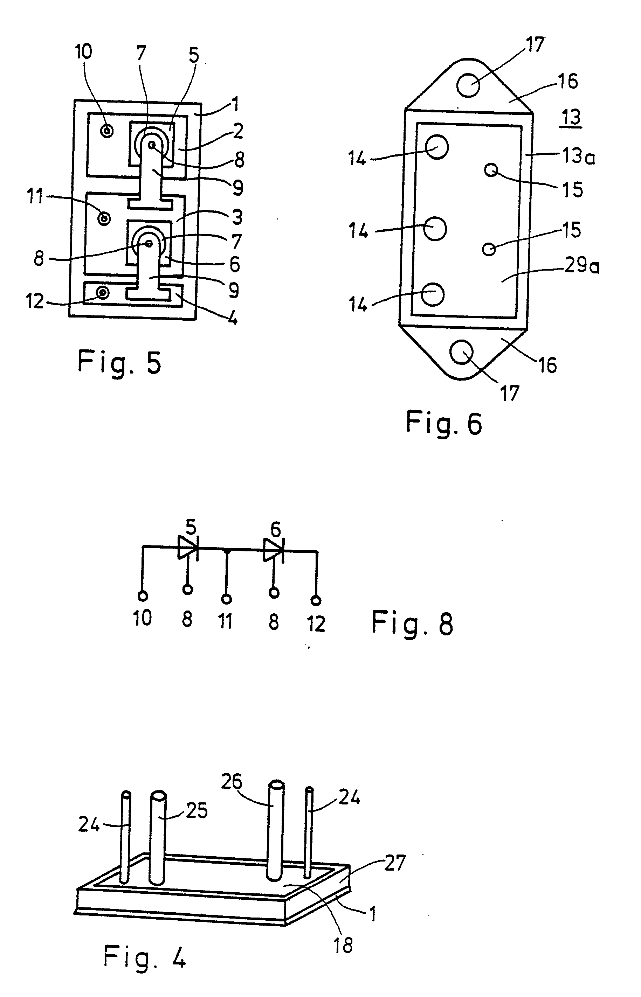

Nach dem Verkleben des Kunststoffrahmens 27 mit der bestückten Keramikplatte 1 wird das so geschaffene Gehäuse mit Gießharz 18 vergossen, und es entsteht ein fertiges Stromrichtermodul wie in Fig. 4 dargestellt. Der Platzbedarf und insbesondere die Bauhöhe des Moduls sind vorteilhaft sehr gering. Die nach oben herausgeführten Anschlußdrähte 24, 25 und 26 eignen sich zum leichten Verlöten auf gedruckten Schaltplatinen.

Das in Fig. 4 abgebildete Modul kann wahlweise noch mit den Anschlußlaschen 16 der Fig. 2 oder 6 zur Befestigung auf einem Kühlkörper oder einer Metallgrundplatte versehen sein ; für eine Leiterplattenmontage allein sind diese Laschen 16 jedoch nicht nötig, da dann die Stromrichteranordnung lediglich durch Verlöten der Anschlußdrähte montiert wird.

In Fig. 3 ist das elektrische Schaltbild zur Stromrichteranordnung gemäß den Figuren 1 und 2 dargestellt, wobei mit Bezugszeichen 24 die Gate-Anschlußdrähte, mit 25 und 26 die Anoden-Kathoden-Anschlußdrähte bezeichnet sind. Die antiparallel liegenden Thyristoren sind mit 5 und 6 bezeichnet.

In Fig. 5 ist als weiteres Ausführungsbeispiel ein Thyristor-Zweigpaar dargestellt. Auf der Keramikplatte 1 sind dabei drei als Leiterbahnen dienende Kupferfolien 2, 3, 4 aufgebracht. Auf die Kupferfolie 2 ist die Halbleitertablette 5 mit ihrer Anodenseite aufgelötet.

Der ringförmige Kathodenkontakt 7 der Halbleitertablette 5 ist über die Verbindungslasche 9 mit der Kupferfolie 3 verbunden, wobei beide Enden der Lasche 9 verlötet sind. Auf die Kupferfolie 3 ist die Halbleitertablette 6 mit der Anode gelötet und dadurch mit der Kathode der Halbleitertablette 5 verbunden. Der ringförmige Kathodenkontakt 7 der Tablette 6 ist über eine Verbindungslasche 9 mit der Kupferfolie 4 verlötet.

Auf die Kupferfolien 2, 3 und 4 sind externe Anschlußdrähte 10, 11 und 12 aufgelötet.

Auf jedem der Gatekontakte 8 ist ein Kopfdraht als externer Steueranschluß direkt aufgelötet.

Auf die so bestückte Keramikplate 1 wird ein Kunststoffrahmen 13 gemäß Fig. 5 aufgelegt und mit der Platte 1 verklebt. Der Rahmen 13 besitzt eine umlaufende Kante 13a mit rechteckförmigem Querschnitt und entspricht in seiner Länge und Breite dabei genau den Keramikplattenabmessungen. Rippe 29 und Stützstrebe 30 der Fig. 2 sind hier als einheitliche Platte 29a ausgebildet, die zur Durchführung der Hauptanschlußdrähte 10, 11, 12 drei Bohrungen 14 sowie zur Durchführung der Steueranschlußdrähte 8 zwei Bohrungen 15 aufweist.

Die Stromrichteranordnung kann wahlweise sowohl mit offener Keramikplatte 1 als Kühlfläche ausgeführt werden, als auch mit einer Metallgrundplatte. Zur Befestigung der Metallgrundplatte können an die beiden Schmalseiten des Rahmens 13 wieder die Anschlußlaschen 16 angeformt sein. Diese Anschlußlaschen 16 weisen jeweilseine Bohrung 17 auf. Mit Hilfe der Laschen 16 kann z. B. eine Aluminiumplatte unter die Keramikplatte 1 genietet werden.

In Fig. 8 ist das zum Thyristor-Zweigpaar gemäß den Figuren 5 und 6 zugehörige elektrische Schaltbild dargestellt. Daraus ist die Antiparallelschaltung der Halbleitertabletten 5, 6 (Thyristoren) mit den beiden Anoden-Kathoden-Anschlüssen 10, 11 und 12 als gemeinsame Anschlußpunkte sowie den Gate-Anschlüssen 8 ersichtlich.

Die Stromrichteranordnung gemäß Fig. 5 kann alternativ auch mit zwei Dioden oder mit jeweils einer Diode und einem Thyristor (Thyristor-Diode-Zweigpaar) bestückt werden.

**Patentansprüche**

1. Stromrichteranordnung mit einem unten offenen, quaderförmigen Kunststoffgehäuse, das mit einer Keramikplatte als Bodenfläche verklebt und mit einer Isolierstoffmasse ausgegossen ist, wobei die Keramikplatte auf der dem Gehäuseinneren zugewandten Fläche mit Leiterbahnen aus Kupferfolien versehen ist, auf die Halbleitertabletten aufgelötet sind, die Halbleitertabletten untereinander durch Verbindungslaschen verbunden sind, Anschlußelemente der Stromrichteranordnung auf der Oberseite des Gehäuses frei zugänglich sind und als Anschlußelemente Drähte oder Flachstecker vorgesehen sind, die senkrecht zur Keramikplatte herausgeführt sind, gekennzeichnet durch folgende Merkmale :

das Gehäuse ist auch oben offen und ist als flacher Rahmen (13, 27) ausgeführt, dessen Länge und Breite genau den Außenabmessungen der Keramikplatte (1) entsprechen,

der Rahmen (27) weist eine umlaufende, im Querschnitt rechteckförmige Kante (28) auf, an die mittig und zum Rahmeninneren hin gerichtet eine schmale, umlaufende Rippe (29) angeformt ist,

an die innere umlaufende Rippe (29) sind Stützstreben (30) zur Umfassung der aus dem Gehäuse geführten Anschlußelemente (24, 25, 26) angeformt.

2. Stromrichteranordnung nach Anspruch 1, dadurch gekennzeichnet, daß Anschlußlaschen (16) mit Bohrungen (17) an die Schmalseiten des Rahmens (13, 27) angeformt sind.

3. Stromrichteranordnung nach Anspruch 2, dadurch gekennzeichnet, daß mit Hilfe der Anschlußlaschen (16) eine Metallplatte unter die Keramikplatte (1) genietet ist.

## Claims

1. Rectifier arrangement having a downwardly open, board-shaped plastic material housing, which is cemented to a ceramic plate as floor surface and which is lined with an insulating material mass, the ceramic plate being provided, on the surface facing the interior of the housing, with conducting paths consisting of copper foils, to which semiconductor tablets are soldered on, which semiconductor tablets are connected to one another by connecting straps, connecting elements of the rectifier arrangement being freely accessible on the top surface of the housing and wires or plugs being provided as connecting elements, which are guided out perpendicular to the ceramic plate, characterized by the following features :

the housing is also upwardly open and is constructed as a flat frame (13, 27), the length and width of which correspond accurately to the external dimensions of the ceramic plate (1),

the frame (27) exhibits a circulating edge (28), which is rectangular in cross-section and on which, centrally and directed towards the interior of the frame, a narrow, circulating rib (29) is formed,

supporting struts (30) to encompass the connecting elements (24, 25, 26) guided out of the housing are formed on the inner circulating rib (29).

2. Rectifier arrangement according to Claim 1, characterized in that connecting straps (16) with bores (17) are formed on the narrow sides of the frame (13, 27).

3. Rectifier arrangement according to Claim 2, characterized in that a metal plate is riveted under the ceramic plate (1) with the aid of the connecting straps (16).

## Revendications

1. Agencement convertisseur de courant, comprenant un boîtier parallélépipédique en matière plastique, ouvert vers le bas, collé à une plaque en céramique constituant la surface de son fond et noyé dans une masse de matière isolante, ladite plaque en céramique étant munie, sur sa surface tournée vers l'intérieur du boîtier, de pistes conductrices en feuille de cuivre sur lesquelles sont soudées des pastilles de semiconducteurs, lesquelles sont interconnectées par des pattes de connexion, des éléments de raccordement de cet agencement convertisseur étant librement accessibles sur le côté supérieur du boîtier, et des fils ou connecteurs plats, sortant perpendiculairement à la plaque en céramique, étant prévus en tant qu'éléments de raccordement, caractérisé par les caractéristiques suivantes :

le boîtier est aussi ouvert vers le haut et est réalisé en tant que cadre plat (13, 27) dont la longueur et la largeur correspondant exactement aux dimensions extérieures de la plaque en céramique (1) ;

le cadre (27) présente un bord périmétrique (28) qui, vu en coupe transversale, est rectangulaire et sur lequel est formée une mince nervure périmétrique (29), occupant une position médiane et dirigée vers l'intérieur du cadre ;

sur cette nervure périmétrique intérieure (29) sont formées des oreilles de soutien (30) pour entourer les éléments de raccordement (24, 25, 26) sortant du boîtier.

2. Agencement selon revendication 1, caractérisé par le fait que des pattes de raccordement (16) dotées de trous (17) sont formées sur les petits côtés du cadre (13, 27).

3. Agencement selon revendication 2, caractérisé par le fait qu'une plaque métallique est rivetée en dessous de la plaque en céramique, à l'aide des pattes de raccordement (16).

Fig. 1

Fig. 2

Fig. 7

Fig. 3

Fig. 5

Fig. 6

Fig. 8

Fig. 4